(19) Europäisches Patentamt
European Patent Office
Office européen des brevets

(11) **EP 4 407 832 A1**

(12) # EUROPEAN PATENT APPLICATION
published in accordance with Art. 153(4) EPC

(43) Date of publication:
**31.07.2024 Bulletin 2024/31**

(21) Application number: **23868341.1**

(22) Date of filing: **13.07.2023**

(51) International Patent Classification (IPC):
*H02J 7/00* (2006.01)    *H02J 3/28* (2006.01)
*G01R 31/392* (2019.01)    *G01R 31/367* (2019.01)

(52) Cooperative Patent Classification (CPC):
**G01R 31/367; G01R 31/392; H02J 3/28; H02J 7/00**

(86) International application number:
**PCT/KR2023/010006**

(87) International publication number:
**WO 2024/063281 (28.03.2024 Gazette 2024/13)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **19.09.2022 KR 20220117636**

(71) Applicant: **LG Energy Solution, Ltd.
Seoul 07335 (KR)**

(72) Inventors:
• **SON, Subin
Daejeon 34122 (KR)**

• **CHO, Jaesung
Daejeon 34122 (KR)**
• **CHAE, Hongmoon
Daejeon 34122 (KR)**
• **CHOI, Bong Hyuk
Daejeon 34122 (KR)**
• **KWON, Gi Duk
Daejeon 34122 (KR)**
• **IM, Jaesung
Daejeon 34122 (KR)**

(74) Representative: **BCKIP Part mbB
Siegfriedstraße 8
80803 München (DE)**

(54) **APPARATUS AND METHOD FOR ESTABLISHING OPERATION PLAN FOR BATTERY SYSTEM COMPRISING NEWLY INSTALLED BATTERIES**

(57)    An apparatus for establishing an operation plan is an apparatus for establishing an operation plan for a battery system to augment old batteries with new batteries and may include at least one processor; and a memory configured to store instructions executed by the at least one processor to determine a number of first batteries initially installed in the battery system based on a preset minimum required amount of discharge energy; and derive operation plan information including a plurality of augmentation time points for second batteries to be sequentially incorporated into the battery system with the first batteries and a number of the second batteries to be incorporated for each of the pluraltiy of augmentation time points, based on the preset minimum required amount of discharge energy and an expected degradation degree of the first batteries.

[Figure 3]

**Description**

[Technical Field]

This application claims priority to and the benefit of Korean Patent Application No.10-2022-0117636 filed in the Korean Intellectual Property Office on September 19, 2022, the entire contents of which are incorporated herein by reference.

The present invention relates to an apparatus and method for establishing an operation plan of a battery system, and more particularly, to an apparatus and method for establishing an operation plan of a battery system which is operated by augmenting old batteries with new batteries.

[Background Art]

An energy storage system relates to renewable energy, batteries that store electric power, and an existing power grid. Recently, as research into smart grid and renewable energy is expanding and the efficiency and the stability of the power system are emphasized, a demand for energy storage systems for power supply and demand control, and power quality improvement is increasing. Depending on a purpose of use, energy storage systems may have different output and capacity. In order to configure a large-capacity energy storage system, a plurality of battery systems may be connected to provide the large-capacity energy storage system.

Typically, energy storage systems are installed at a specific site and operate for a long period of time. In order for the energy storage system to satisfy the amount of discharge energy required by a customer during relevant operation period, a larger number of batteries than necessary must be initially installed in consideration of the deterioration of battery performance over time.

To solve this problem in terms of cost, an energy storage system has been proposed that operates with a minimum number of installed batteries during the initial period of operation, and new batteries are incorporated into the system during operation periods. However, in such an energy storage system, a difference in performance occurs between existing batteries and newly added batteries as time passes, and a problem arises in that the new batteries follow the performance of the previously installed batteries. For example, when discharge of existing batteries that have degraded earlier is terminated first, discharge of newly installed batteries also ends even though additional discharge is possible. The imbalance problem between these batteries worsens as the operating period elapses, and the number of new batteries added to meet the required amount of discharge energy may increase more than necessary.

[Detailed Description of the Invention]

[Technical Problem]

To obviate one or more problems of the related art, embodiments of the present disclosure provide an apparatus for establishing an operation plan for a battery system including newly installed batteries.

To obviate one or more problems of the related art, embodiments of the present disclosure also provide a method for establishing an operation plan for a battery system including newly installed batteries.

The purpose of the present invention to solve the above problems is to provide a battery system including newly installed batteries being operated according to the established operation plan.

[Technical Solution]

In order to achieve the objective of the present disclosure, an apparatus for establishing an operation plan for a battery system to augment old batteries with new batteries and may include at least one processor; and a memory configured to store instructions executed by the at least one processor to:
determine a number of first batteries initially installed in the battery system based on a preset minimum required amount of discharge energy; and derive operation plan information including a plurality of augmentation time points for second batteries to be sequentially incorporated into the battery system with the first batteries and a number of the second batteries to be incorporated for each of the plurality of augmentation time points, based on the preset minimum required amount of discharge energy and an expected degradation degree of the first batteries.

The instructions are further executed by the processor to determine the number of the second batteries to be incorporated at each of the plurality of augmentation time points based on the preset minimum required amount of discharge energy and an expected discharge energy amount according to an expected degradation degree of pre-installed batteries.

The instructions are further executed by the processor to calculate a discharge energy amount and a discharge amount of the second batteries for an Nth augmentation operation period, whrerin the Nth augmentation operation period is a period in which pre-installed batteries and the Nth augmenting second batteries are operated together.

The calculation of the discharge energy amount and the discharge amount of the second batteries is based on a condition that the second batteries have a same discharge time or back-up time as the discharge time of the pre-installed batteries, wherein the discharge time of the pre-installed batteries is based on an expected discharge energy amount according to the expected degradation degree of the pre-installed batteries and a preset total discharge amount.

The instructions are further executed by the processor to calculate the discharge energy amount and the discharge amount of the second batteries at an end of the Nth augmentation operation period based on a condition that the second batteries have the same discharge time orback-up time as the discharge time of the pre-installed batteries, wherein the discharge time of the pre-installed batteries is based on an expected discharge energy amount of the pre-installed batteries at the end of the Nth augmentation operation period and a preset total discharge amount and determine the calculated discharge energy amount and the discharge amount as the discharge energy amount and the discharge amount of the second batteries for the Nth augmentation operation period.

The instructions are further executed by the processor to transmit the discharge energy amount and discharge amount of the first batteries and the second batteries to the battery system based on a condition that the first batteries and the second batteries are operated in the same discharge time during the Nth augmentation operation period.

According to another embodiment of the present disclosure, a method for establishing an operation plan for a battery system, to augment old batteries with new batteries, the method may include determining a number of first batteries initially installed in the battery system based on a preset minimum required amount of discharge energy; and deriving operation plan information including a plurality of augmentation time points for second batteries to be sequentially incorporated into battery system with the first batteries and a number of the second batteries to be incorporated for each of the plurality of augmentation time points, based on the preset minimum required amount of discharge energy and an expected degradation degree of the first batteries.

The method further comprises determining the number of the second batteries to be incorporated at each of the plurality of augmentation time points based on the preset minimum required amount of discharge energy and an expected discharge energy amount according to an expected degradation degree of pre-installed batteries.

The method further comprises calculating a discharge energy amount and a discharge amount of the second batteries for an Nth augmentation operation period, whrerin the Nth augmentation operation period is a period in which pre-installed batteries and the Nth augmenting second batteries are operated together.

The calculation of the discharge energy amount and the discharge amount of the second batteries is based on a condition that the second batteries have a same discharge time or back-up time as the discharge time of the pre-installed batteries, wherein the discharge time of the pre-installed batteries is based on an expeccted discharge energy amount according to the expected degradation degree of the pre-installed batteries and a preset total discharge amount.

The method further comprises calculating the discharge energy amount and the discharge amount of the second batteries at the end of the Nth augmentation operation period based on a condition that the second batteries have the same discharge time or back-up time as the discharge time of the pre-installed batteries, wherein the discharge time of the pre-installed batteries is based on an expected discharge energy amount of the pre-installed batteries at the end of the Nth augmentation operation period and a preset total discharge amount; and determining the calculated discharge energy amount and the discharge amount as the discharge energy amount and the discharge amount of the second batteries for the Nth augmentation operation period.

The method may further include transmitting the discharge energy amount and discharge amount of the first batteries and the second batteries to the battery system based on a condition that the first batteries and the second batteries are operated in the same discharge time during the Nth augmentation operation period.

According to another embodiment of the present disclosure, a battery system to augment old batteires with new batteries may include first batteries that are initially installed; and second batteries that are sequentially incorporated into the battery system with the first batteries, wherein the first batteries are installed in a number determined based on a preset minimum required amount of discharge energy, and wherein the second batteries are sequentially incorporated according to a plurality of augmentation time points and a number of the second batteries to be incorporated for each of the plurality of augmentation time point which are determined based on the preset minimum required amount of discharge energy and an expected degradation degree of the first batteries.

The first batteries and the second batteries may be operated according to respective discharge energy amount and discharge amount which are predefined based on a condition that the first batteries and the second batteries have a same discharge time.

The respective discharge energy amount and discharge amount may be determined based on a discharge energy amount according to an expected degradation degree of the first batteries and a preset total discharge amount.

[Advantageous Effects]

According to the embodiment of the present invention as described above, a number of batteries to be installed in a battery system can be minimized during the entire operation period of the battery system.

In addition, according to an embodiment of the present invention, the overall efficiency can be improved by minimizing the imbalance problem of batteries included in the battery system during the entire operation period.

[Brief Description of the Drawings]

FIG. 1 is a block diagram of an general energy storage system.
FIG. 2 is a block diagram of a general energy storage system including new batteries.
FIG. 3 is a block diagram of a battery system according to embodiments of the present invention.
FIG. 4 is an operational flowchart of a method for establishing an operation plan for a battery system according to embodiments of the present invention.
FIG. 5 is an operational flowchart of a method for deriving operation plan information according to embodiments of the present invention.
FIGS. 6 and 7 are examples of operation plan information according to embodiments of the present invention.
FIG. 8 is an example of a battery system according to a comparative example of the present invention.
FIG. 9 is an example of a battery system according to embodiments of the present invention.
FIG. 10 is a block diagram of an apparatus for establishing an operation plan in according to embodiments of the present invention.
100: fist battery (initially installed battery)
200: second battery (augmenting battery)
200-N: Nth augmenting battery
1000: apparatus for establishing operation plan

[Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Some terms used herein are defined as follows.

State of Charge (SOC) refers to a current state of charge of a battery, represented in percent points [%], and State of Health (SOH) may be a current condition of a battery compared to its ideal or original conditions, represented in percent points [%].

A battery rack refers to a system of a minimum single structure which is assembled by connecting module units in parallel/serial, set by a battery manufacturer, and can be monitored and controlled by a battery management apparatus/system (BMS). A battery rack may include several battery modules and a battery protection unit or any other protection device.

A battery bank refers to a group of large-scale battery rack systems configured by connecting several racks in parallel. A bank BMS for a battery bank may monitor and control several rack BMSs, each of which manages a battery rack.

A battery system controller (BSC) refers to a device that controls the topmost level of a battery system including a battery bank level structure or a multiple bank level structure.

Nominal capacity (Nominal Capa.) refers to a capacity [Ah] of a battery which is set during development by a battery manufacturer.

Hereinafter, exemplary embodiments of the present invention will be described in detail with reference to the accompanying drawings.

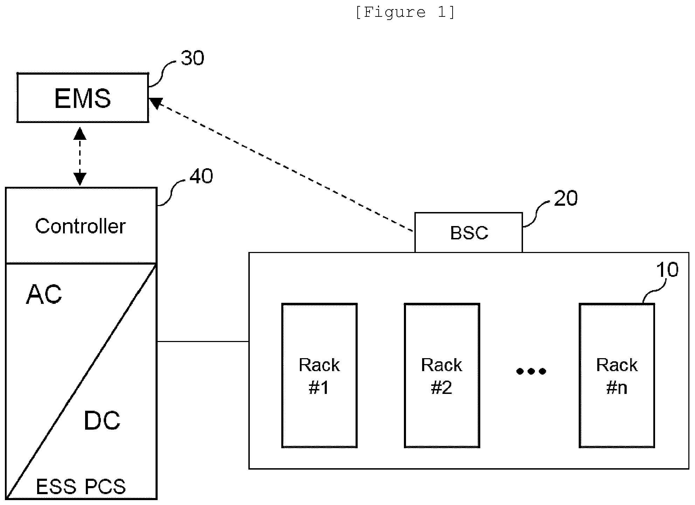

FIG. 1 is a block diagram of a general energy storage system.

In an energy storage system (ESS), typically a battery cell is a minimum unit of storing energy or power. A series/parallel combination of battery cells may form a battery pack, and a plurality of battery packs may form a battery rack. In other words, a battery rack can be a minimum unit of a battery system as a series/parallel combination of battery packs. Here, depending on a device or a system in which the battery is used, a battery pack may be referred to as a battery module.

Referring to FIG. 1, a battery rack may include a plurality of battery modules and a battery protection unit (BPU) 10 or any other protection device. The battery rack can be monitored and controlled through a rack BMS(RBMS). The RBMS may monitor a current, a voltage and a temperature, among others, of each battery rack to be managed, calculate a State Of Charge (SOC) of the battery based on monitoring results, and control charging and discharging of the battery rack.

Meanwhile, the battery protection unit (BPU) is a device for protecting the battery rack from an abnormal current and a fault current in the battery rack. The BPU may include a main contactor (MC), a fuse, a circuit breaker (CB) or a disconnect switch (DS) . The BPU may control a battery system rack by rack through on/off controlling the main contactor (MC) based on a control from the Rack BMS. The BPU 10 may also protect the battery rack from a short circuit current using a fuse in the event of a short circuit. As such, a general battery system can be controlled through a protection device such as a BPU 10 or a switchgear.

In addition, a battery sysesm controller (BSC) 20 is located in each battery section which includes a plurality of batteries, peripheral circuits, and devices to monitor and control objects such as a voltage, a current, a temperature, and a circuit breaker. The battery sysesm controller 20 is an uppermost control device in a battery system including at least one battery bank with a plurality of battery racks. The battery sysem controller 20 may also be used as a control device in a battery system having a plurality of bank level structures.

In addition, a power conversion system (PCS) 40 installed in each battery section performs charging/discharging based on a charge/discharge command (e.g., a charge or discharge command) from the energy management system (EMS) 30. The power conversion system (PCS) 40 may include a power conversion unit (DC/AC inverter) and a controller. The output of each BPU 10 may be connected to a power generating device (e.g., photovoltaic device) and the power conversion system 40 through a DC bus, and the power conversion system 40 may be connected to a power grid. In addition, the energy management system (EMS) 30 or power management system (PMS) may manage the overall energy storage system (ESS).

In such a general energy storage system shown in FIG.1, a plurality of battery racks may serve as voltage sources, and the PCS charges and discharges the battery racks using a constant current (CC) control method or a constant power (CP) control method. At the initial installation of the battery racks, the performances of battery racks are almost similar (if expressed in equivalent resistance, showing similar resistance values), and the charge/discharge current of each rack appears in a similar level. However, some racks may experience degradation over time. In this instance, new racks can be added to the existing energy system so as to supplement the system performance, which may be referred to as augmentation.

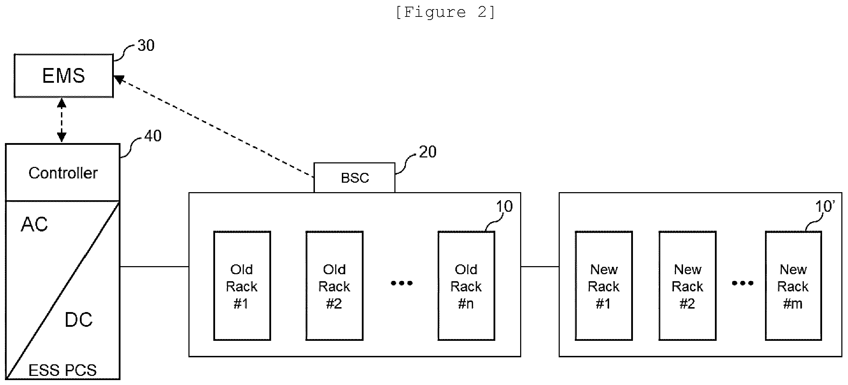

FIG. 2 is a block diagram of a general energy storage system including new batteries.

FIG. 2 shows a system in which an energy storage system (e.g., the energy storage system shown in FIG. 1) including existing battery racks 10 (old racks) is augmentated with a plurality of new battery racks 10' (new racks).

The new battery racks 10' are electrically connected to the existing battery racks 10 and can be controlled to charge and discharge, together with the existing battery racks 10 by a control device of the energy storage system. Here, a performance difference may appear between the new battery racks 10' and the existing battery racks 10, and a problem arises that the new battery racks 10' follow deteriorated performance of the existing battery racks 10. In other words, even though new racks are added, the maximum performance (e.g., nominal capacity, period of use, etc.) of the new racks cannot be fully utilized.

The problem of imbalance between these battery racks worsens as the operation period elapses, and more new battery racks must be added to meet a required amount of discharge energy, thereby ultimately requiring increasing number of battery racks to be installed in the energy storage system during the entire operation period.

Thus, the present invention is presented to solve the problems occurring in the existing energy storage system. The present invention can minimize the number of batteries installed in the battery system during the entire operation period of the energy storage system, and at the same time improve power efficiency by minimizing the problem of imbalance between new batteries and existing batteries .

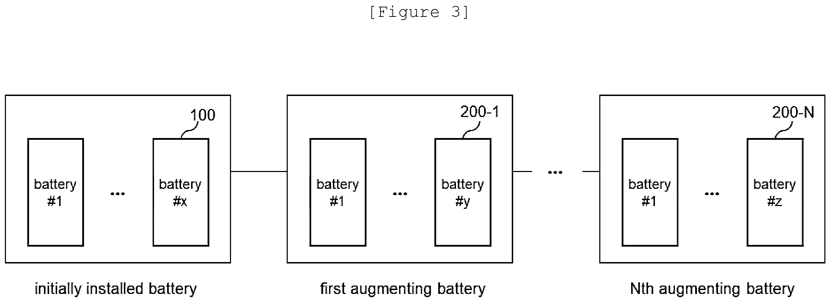

Hereinafter, with reference to FIGS. 3 to 10, a method for establishing an operation plan for a battery system according to various embodiments of the present invention and a battery system operating according to established operation plan information will be described.

FIG. 3 is a block diagram of a battery system according to embodiments of the present invention.

Referring to FIG. 3, a battery system according to embodiments of the present invention may include a plurality of batteries and may be located within an energy storage system shown in FIG. 1 or FIG. 2. Meanwhile, in the present invention, [battery] may mean a battery cell, battery module, battery rack, or battery bank.

The battery system may include initially installed batteries 100 (first battery) and at least one battery 200 (second battery) that is incorporated into the battery system during operation of the battery system.

Here, the second battery 200 may be sequentially incorporated into the first batteries 100 N times. Referring to FIG. 3, the second battery 200 may include a first augmenting battery 200-1 to an Nth augmenting battery 200-N that are sequentially incorporated into the system from the first to the Nth times.

The battery system may be operated based on operation plan information derived by an operation plan establishing apparatus to be described later. The operation plan information according to embodiments of the present invention may include an installation quantity of the first battery, an augmentation time point of the second battery, the quantity of the augmenting second battery at each augmentation point, and discharge energy amount (Wh) and discharge amount (W) of the first and second batteries for each operation section.

The installation quantity of the first batteries, that is, the number of batteries initially installed in the battery system, may be determined based on a preset minimum required amount of discharge energy (e.g., required discharge energy amount by a customer).

Additionally, the augmentation time point of the second batteries and the the quantity of the augmenting second batteries at each augmentation time point may be determined based on the minimum required amount of discharge energy and expected degree of degradation of the battery.

In addition, the discharge energy amount and discharge amount of the first batteries and the second batteries may be defined for each of Nth augmentation operation periods and determined for each of a Nth augmentation operation period so that the first and second batteries have the same discharge time in each of the Nth augmentation operation period. Here, the Nth augmentation operation period refers to a period in which the pre-installed battery and the Nth augmentating second battery are operated together. For example, the first augmentation operation period is a period in which the first battery 100 and the first augmenting battery 200-1 are operated together, the second augmentation operation period is a period in which the first battery 100, the first augmenting battery 200-1, and the second augmenting battery 200-2 are operated together, and the Nth augmentation operation period is a period in which the first battery 100 and the first to Nth augmenting batteries (200-1 - 200-N) are operated together.

In the battery system, the first batteries may be installed and operated according to a number of initial installation batteries included in the operation plan information, and the second batteries (200-1 ~ 200-N) may be sequentially augmentated and operated according to the Nth augmentation time point and augmentation quantity included in the operation plan information. Thereafter, during the Nth augmentation operation period, the first and second batteries may be controlled according to discharge energy amount and discharge amount for each operation period included in the operation plan information. Here, the discharge energy amount and discharge amount included in the operation plan information are pre-derived values so that the first batteries and the second batteries have the same discharge time in each operation period, and thus, performance imbalance between the first batteries and the second batteries can be minimized in the augmentation operation period.

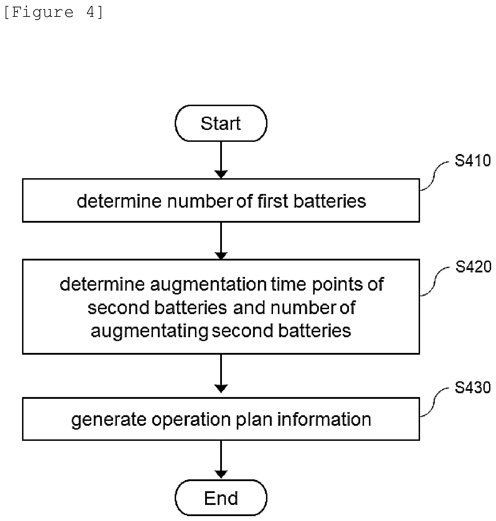

FIG. 4 is an operational flowchart of a method for establishing an operation plan for a battery system according to embodiments of the present invention.

The operation plan establishing apparatus may determine a number of first batteries to be initially installed in the battery system (S410). Here, the operation plan establishing apparatus may determine the number of first batteries based on a preset minimum required amount of discharge energy. For example, if the minimum required amount of discharge energy is set to 1000 [MWh] and each battery rack has a capacity of 335 [KWh], the number of first batteries may be determined to be 3420 to satisfy the minimum required amount of discharge energy during the initial operation period (period of operation with only the first battery).

In embodiments, the operation plan establishing apparatus may determine the number of first batteries by considering the minimum required amount of discharge energy and expected degradation degree of the first batteries. For example, the number of first batteries may be determined as a minimum value of a natural number exceeding [(minimum required amount of discharge energy / discharge energy amount per battery) * α], and α may be defined as a specific value between 1.1 and 1.2. In other words, considering degradation of the first batteries that progresses during the initial operation period (e.g., 5 years), the number of first batteries may be determined as a quantity capable of discharging more than the minimum required amount of discharge energy even at the end of the initial operation period (e.g., 5 years).

The operation plan establishing apparatus may determine the augmentation time point of the second batteries sequentially incorporated into the first batteries and the number of the second batteries to be incorporated for each augmentation time (S420). Here, the operation plan establishing apparatus may determine the augmentation time point of the second batteries and the number of augmentation numbers for each augmentation time based on the minimum required amount of discharge energy and the expected degradation degree of the first batteries.

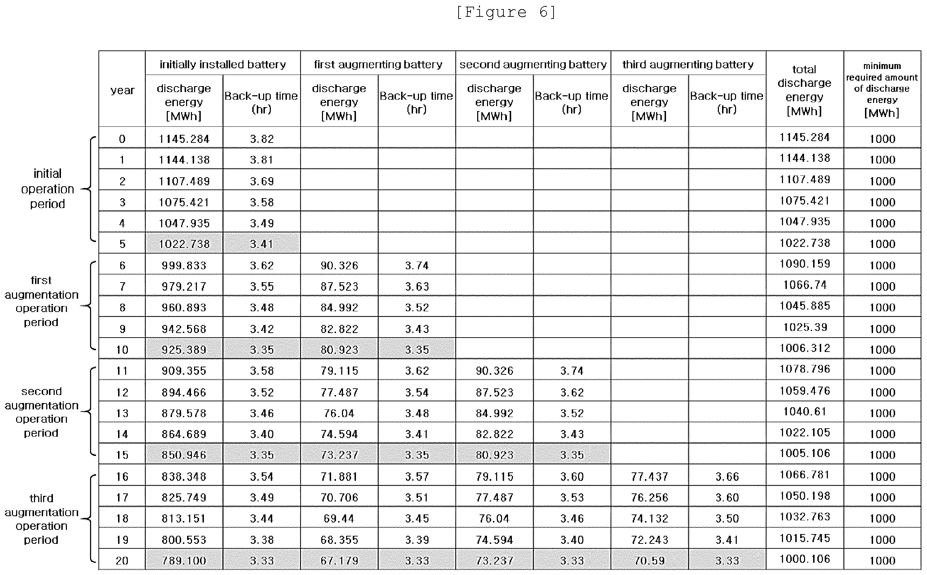

FIG. 6 is an example of operation plan information according to embodiments of the present invention. Referring to FIG. 6, the operation plan establishing apparatus may calculate expected amount of discharge energy (1145.284, 1144.138, ... , 789.100) of the first batteries (initially installed battery) for each unit period (year) of the preset total operation period (20 years). Here, the expected amount of discharge energy may be calculated according to capacity of each first battery (335 KWh), the total number of first batteries (3420), and a predefined expected degradation degree of the first battery. The expected degradation degree may be pre-derived experimentally or pre-derived using a degradation model, and stored in a storage device.

As shown in FIG. 6, the operation plan establishing apparatus may determine a time point (6th year) when the expected amount of discharge energy of the first batteries becomes less than the minimum required amount of discharge energy (1000 MHh) as the first augmentation time point.

The operation plan establishing apparatus may determine the quantity of first augmentation batteries to be augmentated at first augmentation time. Here, the operation plan establishing apparatus may determine the quantity of the first augmentation batteries based on the minimum required amount of discharge energy and the expected discharge energy amount according to the expected degradation degree of the battery. Referring to FIG. 6, the first augmentation operation period may be predefined as 5 years, and the operation plan establishing apparatus may determine the number of second batteries (270) so that the expected total amount of discharge energy at the end of the first augmentation operation period (10th year) exceeds the minimum required amount of discharge energy (1000 MHh).

Thereafter, the operation plan establishing apparatus may determine the quantity of Nth augmenting batteries to be merged at N-th augmentation time using the method described above. In the example shown in FIG. 6, the first augmentation time is determined as year 6 and the number of the first augmentation is determined to be 270, the second augmentation time is determined to be year 11 and the number of the second augmentation is determined to be 270, and the third augmentation time is determined to be year 16 and the number of the third augmentation is determined to be 235.

The operation plan establishing apparatus may generate operation plan information including the number of first batteries determined in steps S410 and S420, the augmentation time points of the second batteries (first to Nth augmentation time points), and the augmentation quantity of the second batteries for each augmentation time point (S430).

The operation plan establishing apparatus may transmit the generated operation plan information to a managing terminal so that the battery system can be initially designed and operated according to the operation plan information.

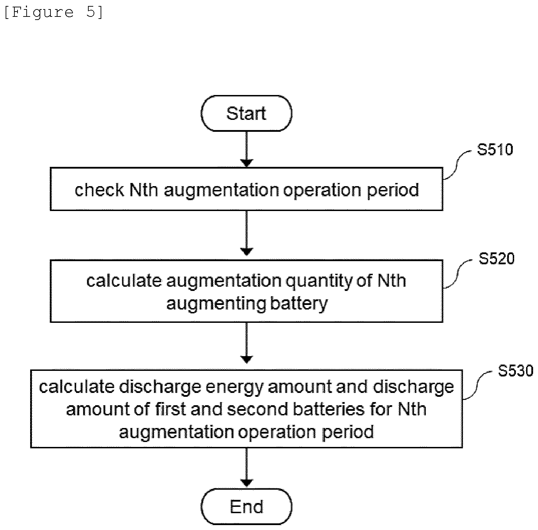

FIG. 5 is an operational flowchart of a method for deriving operation plan information according to embodiments of the present invention. Hereinafter, with reference to FIG. 5, a method for calculating the discharge energy amount (Wh) and discharge amount (W) of the first and second batteries for each Nth augmentation operation section will be described in detail.

The operation plan establishing apparatus may check the Nth augmentation operation period (S510). Specifically, the operation plan establishing apparatus may confirm the augmentation operation period for each preset order. For example, each of the 1st augmentation operation period to the Nth augmentation operation period may be set to 5 years, as shown in FIG. 6.

Here, the operation plan establishing apparatus may determine the Nth augmentation time point based on the Nth augmentation operation period. For example, as shown in FIG. 6, the augmentation time for each order may be determined as the 6th year (the first augmentation time), the 11th year (the second augmentation time), and the 16th year (the third augmentation time).

The operation plan establishing apparatus may calculate the augmentation quantity at the Nth augmentation time point (S520). Here, the operation plan establishing apparatus may determine the quantity of augmentation batteries based on the minimum required discharge energy amount and the expected discharge energy amount according to the expected degradation degree of the already installed battery.

The operation plan establishing apparatus may calculate the discharge energy amount and the discharge amount of the first and second batteries for the Nth augmentation operation period (S530). Here, the operation plan establishing apparatus may generate discharge energy amount and discharge amount of the first and second batteries so that the first and second batteries have the same discharge time based on the expected discharge energy amount of the pre-installed batteries and the preset total discharge amount.

In embodiments, the operation plan establishing apparatus may calculate the discharge energy amount and discharge amount of the first and second batteries for the Nth augmentation operation period based on Equation 1 below.

[Equation 1]

$$(E\_(n-1) \ / \ T\_backup) \ + \ (E\_(n) \ / \ T\_backup) \ = \ P\_total$$

Here, E_(n-1) refers to the expected discharge energy amount of the pre-installed batteries at the end of the Nth augmentation operation period, E_(n) refers to the expected discharge energy amount of the Nth augmentation battery at the end of the Nth augmentation operation period, T_backup refers to the discharge time, and P_total means the total amount of discharge.

The operation plan establishing apparatus may derive the discharge energy amount (E_(n )) and discharge time (T_backup), based on Equation 1 above, which satisfies a condition that the total discharge energy amount in the Nth augmentation operation period exceeds the minimum required amount of discharge energy. The operation plan establishing apparatus may calculate the discharge energy amount and the discharge amount of the first and second batteries for the Nth augmentation operation period using the derived values.

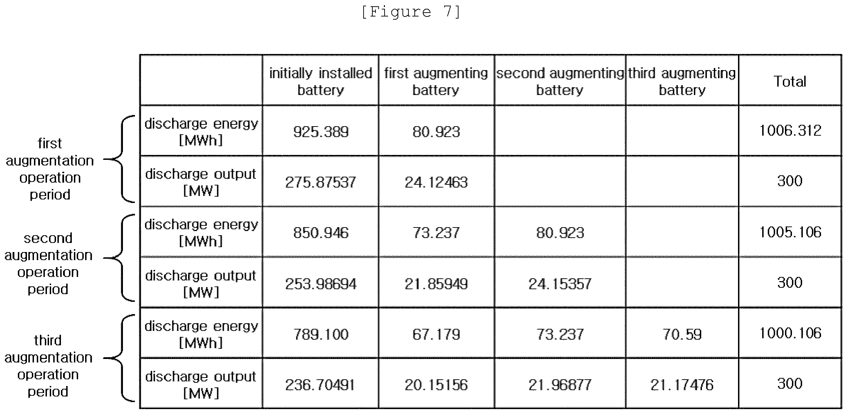

FIG. 7 is an example of operation plan information according to embodiments of the present invention. Referring to FIG. 7, the total discharge amount in all augmentation operation sections may be preset to 300 [MW]. The number of first augmentated batteries may be determined to be 270, as described with reference to FIGS. 4 and 6.

The operation plan establishing apparatus may calculate the discharge energy amount and discharge amount of the first and second batteries for the first augmentation operation period based on Equation 1 above.

$$(E\_(0) \ / \ T\_backup) \ + \ (E\_(1) \ / \ T\_backup) \ = \ P\_total$$

Here, E_(0) is 925.389 [MWh], which is the expected discharge energy amount of the pre-installed battery (i.e., initially installed battery) at the end of the first augmentation operation period, and P_total is 300 [MW].

The operation plan establishing apparatus may derive a discharge energy amount (E_(1)) and a discharge time (T_backup) of the first augmentating batteries that satisfy equation 1 above and the condition that the total amount of discharge energy (the sum of the amount of discharge energy of the initially installed battery and the first augmentating battery) in the first augmentation operation period exceeds the minimum required amount of discharge energy 1000 [MWh]. Here, the operation plan establishing apparatus may terminate the calculation process when values that satisfy equation 1 and conditions are derived, by repeating a process of changing E_(1) and T_backup and substituting them into equation 1 and conditions thereof.

Referring to FIGS. 6 and 7, it is understood that according to the above calculation process, the discharge energy amount (E_(1)) of the first augmentating batteries is derived as 80.923 [MWh] and the discharge time (T_backup) is derived as 3.35 [hr].

The operation plan establishing apparatus may use the derived values to calculate (E_(0) / T_backup) the discharge amount of the first battery (275.87537 [MW]) and the discharge amount of the first augmentating batteries (24.12463 [MW]) may be calculated (E_(1) / T_backup).

Thereafter, the operation plan establishing apparatus may calculate a discharge energy amount and a discharge amount of the first batteries (initial installaed battery) and the second batteries (first to third augmentating batteries) for the second and third augmentation operation periods in the same manner as above (see FIG. 7).

The operation plan establishing apparatus may generate operation plan information including the discharge energy amount and the discharge amount of the first and second batteries for each of the first to Nth augmentation operation periods and transmit it to a control device of the battery system, and thus, the battery system may operate according to the operation plan information. Accordingly, the battery system may be controlled so that the old and new batteries have the same discharge time during all augmentation operation periods, thereby minimizing performance imbalance between batteries and improving power efficiency.

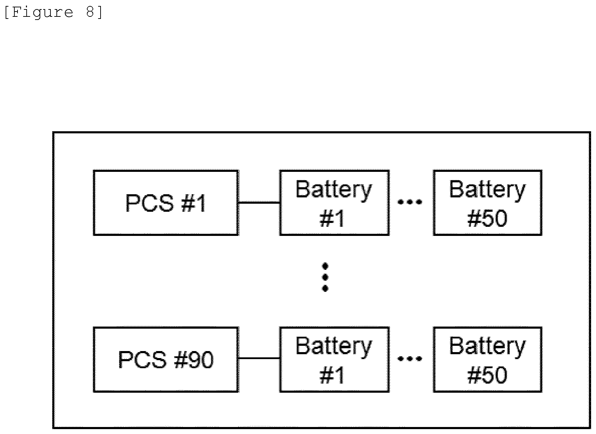

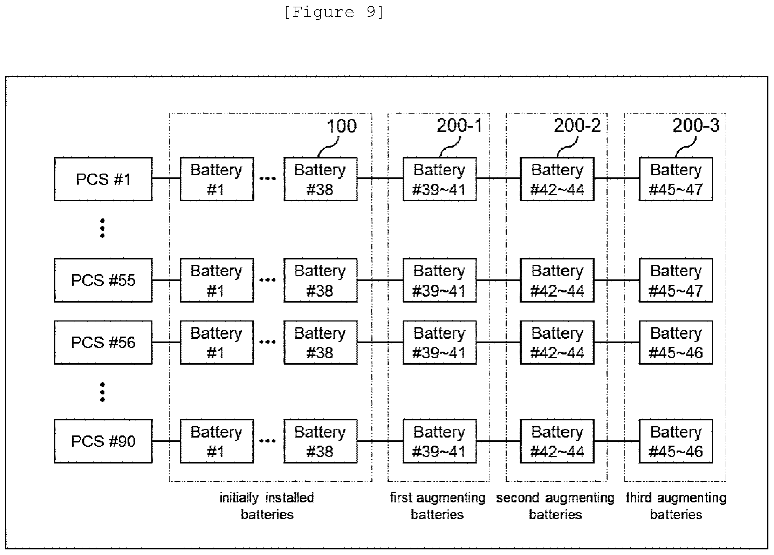

FIG. 8 is an example of a battery system according to a comparative example of the present invention and FIG. 9 is an example of a battery system according to embodiments of the present invention.

The battery system in FIG. 8 is a battery system that does not incorporate new batteries and operates only with initially installed batteries. In the battery system according to the comparative example, 4,500 battery racks, each with a capacity of 335 [KWh], must be initially installed in order to satisfy the minimum required amount of discharge energy (1000 [MHh]) per unit period during the total operation period (20 years).

On the other hand, the battery system according to the embodiment of the present invention shown in FIG. 9 may be operated with 3420 battery racks during the initial operation period, making it possible to design the initial system with a 24% lower number of battery racks than the comparative example.

In addition, in the battery system according to the embodiment of the present invention, the battery racks can be sequentially installed and operated with 270 units in the 6th year, 270 units in the 11th year, and 235 units in the 16th year, and thus, 4195 battery racks are installed during the total operation period, which is possible to operate with a 6.7% lower number of battery racks than the comparative example.

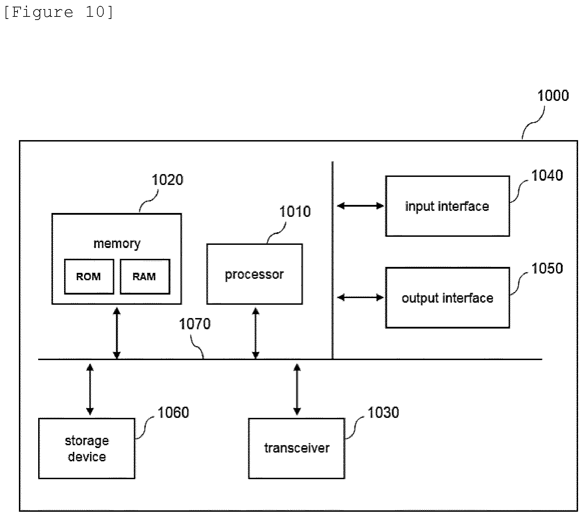

FIG. 10 is a block diagram of an apparatus for establishing an operation plan according to embodiments of the present invention.

The apparatus for establishing an operation plan 1000 according to embodiments of the present invention may include at least one processor 1010, a memory 1020 that stores at least one command executed through the processor, and a transceiver 1030 which is connected to the network to perform communication.

Here, the at least one instruction may include an instruction to derive a number of first batteries initially installed in the battery system based on a preset minimum required amount of discharge energy; and an instruction to derive operation plan information including augmentation time points for the second batteries to be sequentially incorporated into the first batteries and a number of the second batteries to be incorporated for each augmentation time point, based on the minimum required amount of discharge energy and an expected degradation degree of the first batteries.

The instruction to derive the operation plan information may include an instruction to determine the number of the second batteries to be incorporated at each augmentation time based on the minimum required amount of discharge energy and a discharge energy amount according to an expected degradation degree of pre-installed batteries.

The instruction to derive the operation plan information may include an instruction to calculate the discharge energy amount and the discharge amount of the second batteries for Nth augmentation operation period, whrerin the Nth augmentation operation period is defined as a period in which pre-installed batteries and the Nth augmenting second batteries are operated together.

The instruction to calculate the discharge energy amount and the discharge amount of the second batteries for Nth augmentation operation period may include an instruction to calculate the discharge energy amount and the discharge amount of the second batteries so that the second batteries have the same discharge time (back-up time) as the discharge time of the pre-installed batteries based on a discharge energy amount according to the expected degradation degree of the pre-installed batteries and a preset total discharge amount.

The instruction to calculate the discharge energy amount and the discharge amount of the second batteries for Nth augmentation operation period may include an instruction to calculate the discharge energy amount and the discharge amount of the second batteries at the end of the Nth augmentation operation period so that the second batteries have the same discharge time (back-up time) as the discharge time of the pre-installed batteries based on an expected discharge energy amount of the pre-installed batteries at the end of the Nth augmentation operation period and a preset total discharge amount and an instruction to determine the calculated discharge energy amount and the discharge amount as the discharge energy amount and the discharge amount of the second batteries for the Nth augmentation operation period.

The at least one instruction may further include an instruction to transmit the discharge energy amount and discharge amount of the first batteries and the second batteries to the battery system so that the first batteries and the second batteries are operated with the same discharge time during the Nth augmentation operation period.

The apparatus for establishing an operation plan 1000 may further include an input interface 1040, an output interface 1050, a storage device 1060, etc. Respective components included in the apparatus for establishing an operation plan 1000 are connected by a bus 1070 and can communicate with one another.

Here, the processor 1010 may mean a central processing unit (CPU), a graphics processing unit (GPU), or a dedicated processor on which methods according to embodiments of the present invention are performed. The memory (or storage device) may include at least one of a volatile storage medium and a nonvolatile storage medium. For example, the memory may include at least one of read only memory (ROM) and random access memory (RAM).

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit.

In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

**Claims**

1. An apparatus for establishing an operation plan for a battery system to augment old batteries with new batteries, the apparatus comprising:

   at least one processor; and
   a memory configured to store instructions executed by the at least one processor to:

   determine a number of first batteries initially installed in the battery system based on a preset minimum required amount of discharge energy; and
   derive operation plan information including a plurality of augmentation time points for second batteries to be sequentially incorporated into the battery system with the first batteries and a number of the second batteries to be incorporated for each of the plurality of augmentation time points, based on the preset minimum required amount of discharge energy and an expected degradation degree of the first batteries.

2. The apparatus of claim 1, wherein the instructions are further executed by the processor to:
   determine the number of the second batteries to be incorporated at each of the plurality of augmentation time points based on the preset minimum required amount of discharge energy and an expected discharge energy amount according to an expected degradation degree of pre-installed batteries.

3. The apparatus of claim 1, wherein the instructions are further executed by the processor to:
   calculate a discharge energy amount and a discharge amount of the second batteries for an Nth augmentation operation period, whrerin the Nth augmentation operation period is a period in which pre-installed batteries and the Nth augmenting second batteries are operated together.

4. The apparatus of claim 3, wherein calculation of the discharge energy amount and the discharge amount of the second batteries is based on a condition that the second batteries have a same discharge time or back-up time as the discharge time of the pre-installed batteries, wherein the discharge time of the pre-installed batteries is based on an expected discharge energy amount according to the expected degradation degree of the pre-installed batteries and a preset total discharge amount.

5. The apparatus of claim 4, wherein the instructions are further executed by the processor to:

   calculate the discharge energy amount and the discharge amount of the second batteries at an end of the Nth augmentation operation period based on a condition that the second batteries have the same discharge time or back-up time as the discharge time of the pre-installed batteries, wherein the discharge time of the pre-installed batteries is based on an expected discharge energy amount of the pre-installed batteries at the end of the Nth augmentation operation period and a preset total discharge amount; and
   determine the calculated discharge energy amount and the discharge amount as the discharge energy amount and the discharge amount of the second batteries for the Nth augmentation operation period.

6. The apparatus of claim 4, wherein the instructions are further executed by the processor to transmit the discharge energy amount and discharge amount of the first batteries and the second batteries to the battery system based on a conditionthat the first batteries and the second batteries are operated in the same discharge time during the Nth augmentation operation period.

7. A method for establishing an operation plan for a battery system to augment old batteries with new batteries, the method comprising:

   determining a number of first batteries initially installed in the battery system based on a preset minimum required amount of discharge energy; and

deriving operation plan information including a plurality of augmentation time points for second batteries to be sequentially incorporated into the battery system with the first batteries and a number of the second batteries to be incorporated for each of the plurality of augmentation time points, based on the preset minimum required amount of discharge energy and an expected degradation degree of the first batteries.

8. The method of claim 7, further comprising determining the number of the second batteries to be incorporated at each of the plurality of augmentation time points based on the preset minimum required amount of discharge energy and an expected discharge energy amount according to an expected degradation degree of pre-installed batteries.

9. The method of claim 7, further comprising calculating a discharge energy amount and a discharge amount of the second batteries for an Nth augmentation operation period, whrerin the Nth augmentation operation period is a period in which pre-installed batteries and the Nth augmenting second batteries are operated together.

10. The method of claim 9, wherein calculation of the discharge energy amount and the discharge amount of the second batteries is based on a condition that the second batteries have a same discharge time or back-up time as the discharge time of the pre-installed batteries, wherein the discharge time of the pre-installed batteries is based on an expected discharge energy amount according to the expected degradation degree of the pre-installed batteries and a preset total discharge amount.

11. The method of claim 10, further comprising:

calculating the discharge energy amount and the discharge amount of the second batteries at an end of the Nth augmentation operation period based on a condition that the second batteries have the same discharge time orback-up time as the discharge time of the pre-installed batteries, wherein the discharge time of the pre-installed batteries is based on an expected discharge energy amount of the pre-installed batteries at the end of the Nth augmentation operation period and a preset total discharge amount; and
determining the calculated discharge energy amount and the discharge amount as the discharge energy amount and the discharge amount of the second batteries for the Nth augmentation operation period.

12. The method of claim 10, further comprising transmitting the discharge energy amount and discharge amount of the first batteries and the second batteries to the battery system based on a condition that the first batteries and the second batteries are operated in the same discharge time during the Nth augmentation operation period.

13. A battery system to augmentold batteries with new batteries, the system comprising:

first batteries that are initially installed; and
second batteries that are sequentially incorporated into the battery system with the first batteries,
wherein the first batteries are installed in a number determined based on a preset minimum required amount of discharge energy, and
wherein the second batteries are sequentially incorporated according to a plurality of augmentation time points and a number of the second batteries to be incorporated for each of the plurality of augmentation time point which are determined based on the preset minimum required amount of discharge energy and an expected degradation degree of the first batteries.

14. The system of claim 13, wherein the first batteries and the second batteries are operated according to respective discharge energy amount and discharge amount which are predefined based on a condition that the first batteries and the second batteries have a same discharge time.

15. The system of claim 14, wherein the respective discharge energy amount and discharge amount are determined based on a discharge energy amount according to an expected degradation degree of the first batteries and a preset total discharge amount.

[Figure 1]

[Figure 2]

[Figure 3]

initially installed battery        first augmenting battery        Nth augmenting battery

[Figure 4]

```
                    ┌─────────┐
                    │  Start  │
                    └─────────┘
                         │
                         ▼                              S410
        ┌──────────────────────────────────┐
        │  determine number of first batteries │
        └──────────────────────────────────┘
                         │
                         ▼                              S420
        ┌──────────────────────────────────┐
        │  determine augmentation time points of │
        │  second batteries and number of       │
        │  augmentating second batteries        │
        └──────────────────────────────────┘
                         │
                         ▼                              S430
        ┌──────────────────────────────────┐
        │  generate operation plan information │
        └──────────────────────────────────┘
                         │
                         ▼
                    ┌─────────┐
                    │   End   │
                    └─────────┘
```

[Figure 5]

```
                          ┌─────────┐
                          │  Start  │
                          └────┬────┘
                               │
                               ▼                          S510
        ┌──────────────────────────────────────────────┐
        │    check Nth augmentation operation period    │
        └──────────────────────┬───────────────────────┘
                               │
                               ▼                          S520
        ┌──────────────────────────────────────────────┐
        │    calculate augmentation quantity of Nth     │
        │              augmenting battery               │
        └──────────────────────┬───────────────────────┘
                               │
                               ▼                          S530
        ┌──────────────────────────────────────────────┐
        │ calculate discharge energy amount and discharge│
        │  amount of first and second batteries for Nth │
        │          augmentation operation period        │
        └──────────────────────┬───────────────────────┘
                               │
                               ▼
                          ┌─────────┐
                          │   End   │
                          └─────────┘
```

[Figure 6]

| period | year | initially installed battery discharge energy [MWh] | initially installed battery Back-up time (hr) | first augmenting battery discharge energy [MWh] | first augmenting battery Back-up time (hr) | second augmenting battery discharge energy [MWh] | second augmenting battery Back-up time (hr) | third augmenting battery discharge energy [MWh] | third augmenting battery Back-up time (hr) | total discharge energy [MWh] | minimum required amount of discharge energy [MWh] |
|---|---|---|---|---|---|---|---|---|---|---|---|
| initial operation period | 0 | 1145.284 | 3.82 | | | | | | | 1145.284 | 1000 |
| | 1 | 1144.138 | 3.81 | | | | | | | 1144.138 | 1000 |
| | 2 | 1107.489 | 3.69 | | | | | | | 1107.489 | 1000 |
| | 3 | 1075.421 | 3.58 | | | | | | | 1075.421 | 1000 |
| | 4 | 1047.935 | 3.49 | | | | | | | 1047.935 | 1000 |
| | 5 | 1022.738 | 3.41 | | | | | | | 1022.738 | 1000 |
| first augmentation operation period | 6 | 999.833 | 3.62 | 90.326 | 3.74 | | | | | 1090.159 | 1000 |
| | 7 | 979.217 | 3.55 | 87.523 | 3.63 | | | | | 1066.74 | 1000 |
| | 8 | 960.893 | 3.48 | 84.992 | 3.52 | | | | | 1045.885 | 1000 |
| | 9 | 942.568 | 3.42 | 82.822 | 3.43 | | | | | 1025.39 | 1000 |
| | 10 | 925.389 | 3.35 | 80.923 | 3.35 | | | | | 1006.312 | 1000 |
| second augmentation operation period | 11 | 909.355 | 3.58 | 79.115 | 3.62 | 90.326 | 3.74 | | | 1078.796 | 1000 |
| | 12 | 894.466 | 3.52 | 77.487 | 3.54 | 87.523 | 3.62 | | | 1059.476 | 1000 |
| | 13 | 879.578 | 3.46 | 76.04 | 3.48 | 84.992 | 3.52 | | | 1040.61 | 1000 |
| | 14 | 864.689 | 3.40 | 74.594 | 3.41 | 82.822 | 3.43 | | | 1022.105 | 1000 |
| | 15 | 850.946 | 3.35 | 73.237 | 3.35 | 80.923 | 3.35 | | | 1005.106 | 1000 |
| third augmentation operation period | 16 | 838.348 | 3.54 | 71.881 | 3.57 | 79.115 | 3.60 | 77.437 | 3.66 | 1066.781 | 1000 |
| | 17 | 825.749 | 3.49 | 70.706 | 3.51 | 77.487 | 3.53 | 76.256 | 3.60 | 1050.198 | 1000 |
| | 18 | 813.151 | 3.44 | 69.44 | 3.45 | 76.04 | 3.46 | 74.132 | 3.50 | 1032.763 | 1000 |
| | 19 | 800.553 | 3.38 | 68.355 | 3.39 | 74.594 | 3.40 | 72.243 | 3.41 | 1015.745 | 1000 |
| | 20 | 789.100 | 3.33 | 67.179 | 3.33 | 73.237 | 3.33 | 70.59 | 3.33 | 1000.106 | 1000 |

[Figure 7]

| | initially installed battery | first augmenting battery | second augmenting battery | third augmenting battery | Total |
|---|---|---|---|---|---|
| **first augmentation operation period** — discharge energy [MWh] | 925.389 | 80.923 | | | 1006.312 |
| discharge output [MW] | 275.87537 | 24.12463 | | | 300 |
| **second augmentation operation period** — discharge energy [MWh] | 850.946 | 73.237 | 80.923 | | 1005.106 |
| discharge output [MW] | 253.98694 | 21.85949 | 24.15357 | | 300 |
| **third augmentation operation period** — discharge energy [MWh] | 789.100 | 67.179 | 73.237 | 70.59 | 1000.106 |
| discharge output [MW] | 236.70491 | 20.15156 | 21.96877 | 21.17476 | 300 |

[Figure 8]

[Figure 9]

initially installed batteries | first augmenting batteries | second augmenting batteries | third augmenting batteries

EP 4 407 832 A1

[Figure 10]

## INTERNATIONAL SEARCH REPORT

| | International application No. |
|---|---|
| | **PCT/KR2023/010006** |

| A. | CLASSIFICATION OF SUBJECT MATTER |
|---|---|

**H02J 7/00**(2006.01)i; **H02J 3/28**(2006.01)i; **G01R 31/392**(2019.01)i; **G01R 31/367**(2019.01)i

According to International Patent Classification (IPC) or to both national classification and IPC

| B. | FIELDS SEARCHED |
|---|---|

Minimum documentation searched (classification system followed by classification symbols)

H02J 7/00(2006.01); G01R 31/36(2006.01); H02J 3/28(2006.01); H02J 3/32(2006.01); H02J 7/02(2006.01); H02J 7/04(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 운영(operation), 퇴화(degeneration), 병합(merge)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-2017-0062132 A (LG CHEM, LTD.) 07 June 2017 (2017-06-07)<br>See paragraphs [0021]-[0054]; and figures 1-3b. | 1-2,7-8,13-15 |
| A | | 3-6,9-12 |
| Y | KR 10-2030872 B1 (LG CHEM, LTD.) 10 October 2019 (2019-10-10)<br>See paragraphs [0009], [0096]-[0110] and [0188]-[0190]; and figures 3-4. | 1-2,7-8,13-15 |
| A | KR 10-2018-0049543 A (LOCOS CO., LTD.) 11 May 2018 (2018-05-11)<br>See paragraphs [0073]-[0081]; and figure 4. | 1-15 |
| A | JP 2014-171335 A (TOSHIBA CORP.) 18 September 2014 (2014-09-18)<br>See entire document. | 1-15 |
| A | US 10205327 B2 (SAMSUNG SDI CO., LTD.) 12 February 2019 (2019-02-12)<br>See entire document. | 1-15 |

☐ Further documents are listed in the continuation of Box C.　　☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **24 October 2023** | **24 October 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.

**PCT/KR2023/010006**

| Patent document cited in search report | | | Publication date (day/month/year) | Patent family member(s) | | | Publication date (day/month/year) |
|---|---|---|---|---|---|---|---|
| KR | 10-2017-0062132 | A | 07 June 2017 | None | | | |
| KR | 10-2030872 | B1 | 10 October 2019 | KR | 10-2017-0057648 | A | 25 May 2017 |
| KR | 10-2018-0049543 | A | 11 May 2018 | None | | | |
| JP | 2014-171335 | A | 18 September 2014 | CN | 105027379 | A | 04 November 2015 |
| | | | | CN | 105027379 | B | 25 May 2018 |
| | | | | EP | 2966751 | A1 | 13 January 2016 |
| | | | | EP | 2966751 | A4 | 17 August 2016 |
| | | | | EP | 2966751 | B1 | 15 November 2017 |
| | | | | ES | 2657417 | T3 | 05 March 2018 |
| | | | | JP | 6157880 | B2 | 05 July 2017 |
| | | | | KR | 10-1725701 | B1 | 10 April 2017 |
| | | | | KR | 10-2015-0106912 | A | 22 September 2015 |
| | | | | US | 2016-0013670 | A1 | 14 January 2016 |
| | | | | US | 9825474 | B2 | 21 November 2017 |
| | | | | WO | 2014-136705 | A1 | 12 September 2014 |
| US | 10205327 | B2 | 12 February 2019 | KR | 10-2016-0094228 | A | 09 August 2016 |
| | | | | KR | 10-2332337 | B1 | 29 November 2021 |
| | | | | US | 2016-0226268 | A1 | 04 August 2016 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• KR 1020220117636